# EUROPÄISCHE PATENTSCHRIFT

(11) **EP 2 363 898 B1**
(45) Veröffentlichungstag und Bekanntmachung des Hinweises auf die Patenterteilung: **09.09.2015**
(21) Anmeldenummer: 11151820.5
(22) Anmeldetag: 24.01.2011
(51) Int. Cl.: H01L 41/053, H01L 41/23

(54) **Piezoelektrischer Wandler und Verfahren zu dessen Herstellung**
Piezoelectric converter and method for its manufacture
Convertisseur piézoélectrique et son procédé de fabrication

(30) Priorität: 02.03.2010 DE 102010002508
(43) Veröffentlichungstag der Anmeldung: 07.09.2011
(73) Patentinhaber: Robert Bosch GmbH, 70442 Stuttgart (DE)
(72) Erfinder: Cromme, Peter, 96050, Bamberg (DE); Sommariva, Helmut, 8053, Graz (AT)

(56) Entgegenhaltungen:
- DE-A1- 19 909 451
- DE-A1-102007 037 550

## Beschreibung

Die vorliegende Erfindung betrifft einen piezoelektrischen Wandler und ein Verfahren zu dessen Herstellung.

### Stand der Technik

Bei der Herstellung von piezoelektrischen Wandlern, insbesondere auf Blei-Zirkonium-Titanat-Basis, so genannten Piezo-(PZT)-Aktoren oder -Sensoren, wird herkömmlicherweise nach dem Löten der Außenelektroden ein wässriger Waschprozess zum Entfernen von Lötrückständen, insbesondere Lötflussmittelrückständen und Dampfphasenlötrückständen, durchgeführt. Durch die Verwendung eines wässrigen Waschmediums ergeben sich hierbei jedoch eine Reihe von Nachteilen:
So weist Wasser einen niedrigen Dampfdruck auf, weshalb derzeit eine lange und aufwendige Trocknung des Wandlers erforderlich ist.

Weiterhin können in der Waschlösung vorhandenen Tenside und reinigungsaktive Substanzen über van-der-Waals- und/oder ionische Wechselwirkungen an die Wandleroberfläche binden und von dort - auch durch den Trocknungsschritt - nicht mehr vollständig entfernt werden.

Darüber hinaus ist zumindest ein Teil der adsorbierten Stoffe herkömmlicherweise hygroskopisch und zieht während der weiteren Prozessierung des Wandlers Wasser. Das Wasser auf der Wandleroberfläche führt wiederum zu einer erhöhten Oberflächenleitfähigkeit und somit zu einem reduzierten elektrischen Widerstand (RIS: Isolationswiderstand) des Wandlers.

Ein reduzierter elektrischer Widerstand, und damit ein nicht ausreichender Isolationswiderstand, des Wandlers macht jedoch einen bedeutenden Anteil am Gesamtausschuss bei der Wandlerfertigung aus.

Ferner begrenzen die adsorbierten hygroskopisch Stoffe selbst bei fertig prozessierten Wandlern die maximal mögliche Verweilzeit an Luft, insbesondere beim Verbau der Wandler zu Injektoren.

Aus der DE 10 2007 037 550 A1 ein Aktor bekannt, dessen Aussenschicht aus einer duroplastischen Formmasse gebildet ist, wobei der Aktor mit einem Haftvermittler beschichtet ist uns zwischen dem Haftvermittler und der Aussenschicht eine Zwischenschicht auf Basis eines Fluorkautschuks ausgebildet ist. Ein weiterer Aktor ist aus DE 199 09 451 A1 bekannt.

### Offenbarung der Erfindung

### Vorteile der Erfindung

Der erfindungsgemäße piezoelektrischer Wandler ist dadurch gekennzeichnet, dass dessen Oberfläche eine hydrophobe Beschichtung und einen Elektroisolierlack aufweist, wobei der Elektroisolierlack direkt auf die hydrophobe Beschichtung aufgebracht ist.

Die hydrophobe Beschichtung hat den Vorteil, dass kein oder nur wenig Wasser und keine oder nur noch wenige hygroskopische Stoffe an der Oberfläche des Wandlers angelagert werden. Vorteilhafterweise kann dadurch der aus einem reduzierten elektrischen Widerstand resultierende Ausschuss (RIS-Ausschuss) bei der Wandler- und Injektorfertigung sowie die Trocknungszeit reduziert werden. Darüber hinaus ist der erfindungsgemäße Wandler vorteilhafterweise auch beim späteren Einsatz wesentlich robuster gegenüber Umwelteinflüssen. In vorteilhafter Weise ist der Elektroisolierlack direkt, ohne Zwischenschicht, auf die hydrophobe Beschichtung aufgebracht. Dies hat den Vorteil, dass auf eine weitere Zwischenschicht verzichtet werden kann, da die Kombination der hydrophoben Beschichtung und des Elektroisolierlacks für eine Beständigkeit des piezoelektrischen Wandlers gegenüber Wasser sorgt und der Wandler zudem elektrisch isoliert ist.

Es ist von Vorteil, den Elektroisolierlack auf Basis eines Epoxidharzes, insbesondere eines modifizierten Epoxidharzes zu bilden. Das modifizierte Epoxidharz kann zusätzlich Silikonpartikel enthalten. Ferner kann der Elektroisolierlack auch auf Basis eines anderen Polymers gebildet sein, das mindestens eine Epoxidgruppe aufweist.

Bei dem piezoelektrischen Wandler kann es sich im Rahmen der vorliegenden Erfindung sowohl um einen Aktor als auch einen Sensor handeln. Beispielsweise kann es sich bei dem piezoelektrischen Wandler im Rahmen der vorliegenden Erfindung um einen Aktor handeln. Insbesondere kann es sich bei dem piezoelektrischen Wandler im Rahmen der vorliegenden Erfindung um einen piezoelektrischen Wandler auf Blei-Zirkonium-Titanat-Basis, beispielsweise einen piezoelektrischen Wandler dessen Oberfläche ein Blei-Zirkonium-Titanat aufweist, handeln. Zum Beispiel kann es sich bei dem piezoelektrischen Wandler im Rahmen der vorliegenden Erfindung um einen Wandler mit mindestens einem, insbesondere aufgelöteten, Bauteil, beispielsweise einer Außenelektrode, handeln.

Im Rahmen der vorliegenden Erfindung kann die hydrophobe Beschichtung die Oberfläche des Wandlers sowohl teilweise als auch vollständig bedecken. Dies gilt auch für die Bedeckung des Elektroisolierlacks auf der hydrophoben Beschichtung.

Für die hydrophobe Beschichtung eignen sich unter anderem bestimmte Klassen von so genannten Silanen. Silane haben den Vorteil, dass diese insbesondere zu anorganischen, oxidischen Materialien eine dauerhafte chemische Bindung ausbilden können. Die Oberflächeneigenschaften der behandelten Oberfläche können daher vorteilhafterweise je nach der chemischen Natur der in der Beschichtung verwendeten Silane gezielt eingestellt werden. Erfindungsgemäß bildet die hydrophobe Beschichtung die Basis, auf die der Elektroisolierlack direkt aufgebracht ist.

Im Rahmen einer bevorzugten Ausführungsform des erfindungsgemäßen Wandlers umfasst die hydrophobe Beschichtung mindestens ein Silan. Durch eine Beschichtung mit einem hydrophoben Silan kann bewerkstelligt werden, dass die Wandleroberfläche Wasser abstößt und weder Wasser noch die in der Waschlösung vorhandenen hygroskopischen Stoffe auf der Wandleroberfläche gebunden beziehungsweise adsorbiert werden. Dies hat wie bereits erläutert den Vorteil, dass der elektrische Oberflächenwiderstand von teilprozessierten und fertigen Wandlern nicht mehr durch Wechselwirkungen mit Luftfeuchtigkeit sinkt, Leckströme vermieden werden können und die Ausbeute steigt.

Für die Konditionierung des Wandlers ist eine stabile und gegebenenfalls selektive Bindung des Silans an der, insbesondere Blei-Zirkonium-Titanat-, Oberfläche des Wandlers wichtig. Eine besonders stabile Bindung zur Oberfläche bilden Silane mit drei oder sechs oberflächenaktiven, chemischen Gruppen aus.

Im Rahmen einer weiteren, bevorzugten Ausführungsform des erfindungsgemäßen Wandlers umfasst die hydrophobe Beschichtung daher mindestens ein Silan mit drei oder sechs oberflächenaktiven, chemischen Gruppen.

Unter einer "oberflächenaktiven, chemischen Gruppe eines hydrophoben Silans" wird im Rahmen der vorliegenden Erfindung eine chemische Gruppe verstanden, die geeignet eine Bindung des hydrophoben Silans an anorganische, oxidische Materialien zu bewirken. Beispielsweise kann es sich bei der "oberflächenaktiven, chemischen Gruppe eines hydrophoben Silans" um eine Alkoxy-, Acyloxy-, Halogen- oder Amingruppen handeln. Aufgrund der Bindigkeit von Silizium, weist ein hydrophobes Silan mit sechs oberflächenaktiven, chemischen Gruppen mindestens zwei Siliziumatome, insbesondere mit jeweils drei oberflächenaktiven, chemischen Gruppen, auf.

Das hydrophobe Silan stellt die Basis da, auf die der Elektroisolierlack aufgebracht wird. Hierfür ist es von besonderem Vorteil, wenn zwischen der hydrophoben Beschichtung und dem Isolierlack eine dauerhafte chemische Bindung ausgebildet wird. Hierfür müssen die verwendeten Silane der hydrophoben Beschichtung im Rest R mindestens eine chemische Gruppe (z.B.: C-C Doppelbindungen, -NH2 oder -OH Gruppen etc.) aufweisen, die mit dem anschließend applizierten Elektroisolierlack eine chemische Verbindung eingehen können. Die C-C Doppelbindung als aktive Gruppe ist in diesem Zusammenhang besonders gut geeignet. Darüber hinaus ist die Silanschicht hydrophob, um beispielsweise am Aktor kondensierendes Wasser von diesem fernzuhalten.

Für eine Applikation von Silanen und dem Elektroisolierlack vor dem Löten, insbesondere der Außenelektroden, ist darauf zu achten, dass das oder die Silane bei der maximalen Löttemperatur stabil sind und beispielsweise nicht durch ein Waschmedium entfernt werden.

Im Rahmen einer weiteren, bevorzugten Ausführungsform des erfindungsgemäßen Wandlers umfasst die hydrophobe Beschichtung daher Silane, die bis zu einer Temperatur von 240 °C, insbesondere 350 °C, stabil sind beziehungsweise die sich bis zu einer Temperatur von 240 °C, insbesondere 350 °C, nicht oder nur geringfügig zersetzen.

Zu den Silanen die bis Temperaturen oberhalb von 350 °C stabil sind gehören vor allem Gamma und aromatisch substituierte Silane.

Im Rahmen einer weiteren, bevorzugten Ausführungsform des erfindungsgemäßen Wandlers umfasst die hydrophobe Beschichtung daher Gamma und/oder aromatisch substituierte Silane. Unter einem "Gamma substituierten Silan" wird dabei insbesondere ein Silan verstanden, dessen Siliziumatom über eine Kette aus drei Kohlenstoffatomen, beispielsweise eine Propylen-Kette, mit einer funktionalen, insbesondere hydrophoben, Gruppe "R" verbunden ist.

Im Rahmen einer besonders bevorzugten Ausführungsform des erfindungsgemäßen Wandlers umfasst die hydrophobe Beschichtung mindestens ein Silan der allgemeinen Formel (I):

R-(CH₂)ₙ-Tₘ-SiX₃

und/oder mindestens ein Silan der allgemeinen Formel (II):

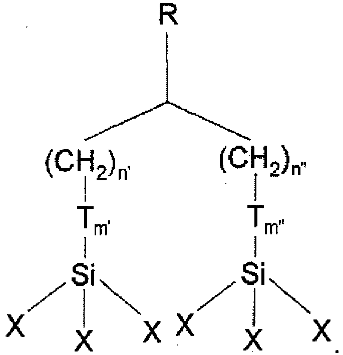

Silan der allgemeinen Formel (I) und (II) sind insbesondere deshalb vorteilhaft, da diese eine besonders stabile Bindung zur Wandleroberfläche ausbilden können.

Beispielsweise kann die hydrophobe Beschichtung im Rahmen dieser Ausführungsform aus mindestens einem Silan der allgemeinen Formel (I) und/oder mindestens einem Silan der allgemeinen Formel (II) ausgebildet sein.

Im Rahmen dieser Ausführungsform steht X für eine Alkoxy-, Acyloxy-, Halogen- oder Amingruppe. Beispielsweise kann X im Rahmen dieser Ausführungsform für eine Methoxy-Gruppe, eine Ethoxy-Gruppe, eine Acyloxy-Gruppe mit 1 bis 10 Kohlenstoffatomen, insbesondere 1 bis 3 Kohlenstoffatomen, Chlor oder eine primäre Amingruppe stehen.

T steht im Rahmen dieser Ausführungsform für eine substituierte oder unsubstituierte Arylen-Gruppe, insbesondere Phenylen-Gruppe oder eine substituierte oder unsubstituierte Arylalkenylen- oder Arylalkylen-Gruppe, insbesondere eine Phenylalkenylen- oder Phenylalkylen-Gruppe, mit 7 bis 20, beispielsweise 8 bis 20, Kohlenstoffatomen. Die Arylalkenylen- oder Arylalkylen-Gruppe, ist dabei vorzugsweise über die Alkenylbeziehungsweise Alkyl-Gruppe an das Siliziumatom und über die Arylgruppe an die -(CH₂)ₙ-Gruppe gebunden.

m, m', m" stehen im Rahmen dieser Ausführungsform jeweils unabhängig von einander für 0, 1 oder 2, insbesondere 0 oder 1.

n, n', n" stehen im Rahmen dieser Ausführungsform jeweils unabhängig von einander für eine Zahl ≥ 0 und ≤ 10, beispielsweise für 0, 1, 2 oder 3, insbesondere für 2 oder 3.

R steht im Rahmen dieser Ausführungsform für eine halogenierte oder unhalogenierte, insbesondere perfluorierte, Alkenyl- oder Alkyl-Gruppe. Beispielsweise kann R im Rahmen dieser Ausführungsform für eine Vinyl-Gruppe, eine Ethyl-Gruppe, eine Propyl-Gruppe oder eine perfluorierte, lineare Alkylgruppe mit 1 bis 20 Kohlenstoffatomen, insbesondere 1 bis 12 Kohlenstoffatomen, zum Beispiel eine Heptadecafluoroctyl-Gruppe, stehen.

Die Anzahl n, n', n" der CH₂-Gruppen und der Rest R bestimmen dabei maßgeblich die Hydrophobie der durch die Beschichtung konditionierten Wandleroberfläche.

Im Rahmen einer weiteren, besonders bevorzugten Ausführungsform des erfindungsgemäßen Wandlers umfasst die hydrophobe Beschichtung mindestens ein Silan der allgemeinen Formel (III):

R-(CH₂)₃-SiX₃

und/oder mindestens ein Silan der allgemeinen Formel (IV):

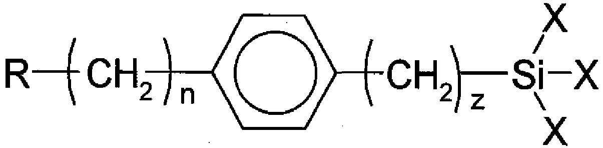

Silan der allgemeinen Formel (III) und (IV) sind insbesondere deshalb vorteilhaft, da diese über eine hohe Temperaturstabilität verfügen können.

Beispielsweise kann die hydrophobe Beschichtung im Rahmen dieser Ausführungsform aus mindestens einem Silan der allgemeinen Formel (III) und/oder mindestens einem Silan der allgemeinen Formel (IV) ausgebildet sein.

Im Rahmen dieser Ausführungsform steht X ebenfalls für eine Alkoxy-, Acyloxy-, Halogen- oder Amingruppe. Beispielsweise kann X im Rahmen dieser Ausführungsform für eine Methoxy-Gruppe, eine Ethoxy-Gruppe, eine Acyloxy-Gruppe mit 1 bis 10 Kohlenstoffatomen, insbesondere 1 bis 3 Kohlenstoffatomen, Chlor oder eine primäre Amingruppe stehen.

n und z stehen im Rahmen dieser Ausführungsform jeweils unabhängig von einander für eine Zahl ≥ 0 und ≤ 10, beispielsweise für 0, 1, 2 oder 3, insbesondere für 0, 2 oder 3.

R steht im Rahmen dieser Ausführungsform ebenfalls für eine halogenierte oder unhalogenierte, insbesondere perfluorierte, Alkenyl- oder Alkyl-Gruppe. Beispielsweise kann R im Rahmen dieser Ausführungsform für eine Vinyl-Gruppe, eine Ethyl-Gruppe, eine Propyl-Gruppe oder eine perfluorierte, lineare Alkylgruppe mit 1 bis 20 Kohlenstoffatomen, insbesondere 1 bis 12 Kohlenstoffatomen, zum Beispiel eine Heptadecafluoroctyl-Gruppe, stehen.

Ein weiterer Gegenstand der vorliegenden Erfindung ist ein Verfahren zur Herstellung, beziehungsweise zur Konditionierung der Oberfläche, von piezoelektrischen Wandlern, insbesondere auf Blei-Zirkonium-Titanat-Basis, in dem die Oberfläche des Wandlers
- vor dem Löten von Bauteilen, insbesondere mindestens einer Außenelektrode, und/oder
- vor dem Waschen mit einer, insbesondere wässrigen, Waschlösung, und/oder
- nach dem Waschen mit einer, insbesondere wässrigen, Waschlösung,
teilweise oder vollständig mit einer hydrophoben Beschichtung versehen wird und anschließend mit einem Elektroisolierlack versehen wird, wobei der Elektroisolierlack direkt auf die hydrophobe Beschichtung aufgebracht wird.

Zunächst wird ein hydrophobes Silan appliziert, wobei eine geeignete Bindung des Elektroisolierlacks mittels des hydrophoben Silans an der Aktoroberfläche bewirkt wird.

Die Applikation der Beschichtung vor dem Löten hat wie bereits erläutert den Vorteil, dass anschließend Lötrückstände durch Waschen mit einer Waschlösung entfernt werden können, ohne dass sich dabei Wasser und, insbesondere hygroskopische, Verbindungen der Waschlösung auf der Wandleroberfläche ablagern und den elektrischen Oberflächenwiderstand reduzieren.

Im nächsten Schritt stellt das hydrophobe Silan die Basis dar, auf die der Elektroisolierlack aufgebracht wird. Hierfür ist es von besonderem Vorteil, wenn zwischen der hydrophoben Beschichtung und dem Isolierlack eine dauerhafte chemische Bindung ausgebildet wird. Hierfür müssen die verwendeten Silane der hydrophoben Beschichtung im Rest R mindestens eine chemische Gruppe (z.B.: C-C Doppelbindungen, -NH2 oder -OH Gruppen etc.) aufweisen, die mit dem anschließend applizierten Elektroisolierlack eine chemische Verbindung eingehen können. Die C-C Doppelbindung als aktive Gruppe ist in diesem Zusammenhang besonders gut geeignet.

Überraschenderweise hat sich herausgestellt, dass auch eine Applikation der Beschichtung nach dem Waschen mit einer, insbesondere wässrigen, Waschlösung vorteilhaft sein kann, da in der Regel die Bindungen zwischen der hydrophoben Beschichtung, insbesondere dem oder den hydrophoben Silanen der hydrophoben Beschichtung, und der, insbesondere Blei-Zirkonium-Titanat-, Oberfläche des Wandlers energetisch günstiger ist als die van-der-Waals-Wechselwirkungen von Wasser und den, insbesondere hygroskopische, Verbindungen der Waschlösung. Wasser und die hygroskopischen Verbindungen können somit von der Wandleroberfläche verdrängt und durch die hydrophobe Beschichtung, insbesondere die hydrophoben Silane der Beschichtung, ersetzt werden.

Im Rahmen einer bevorzugten Ausführungsform des erfindungsgemäßen Verfahrens umfasst die hydrophobe Beschichtung mindestens ein Silan.

Für eine Applikation von Silanen vor dem Löten, insbesondere der Außenelektroden, ist darauf zu achten, dass das oder die Silane bei der maximalen Löttemperatur stabil sind und beispielsweise nicht durch ein Waschmedium entfernt werden.

Im Rahmen einer weiteren, bevorzugten Ausführungsform des erfindungsgemäßen Verfahrens umfasst die hydrophobe Beschichtung daher Silane, bis zu einer Temperatur von 240 °C, insbesondere 350 °C, stabil sind beziehungsweise die sich bis zu einer Temperatur von 240 °C, insbesondere von 350 °C, nicht oder nur geringfügig zersetzen.

Im Rahmen einer besonders bevorzugten Ausführungsform des erfindungsgemäßen Verfahrens umfasst die hydrophobe Beschichtung mindestens ein Silan der allgemeinen Formel (I):

R-(CH₂)ₙ-Tₘ-SiX₃

und/oder mindestens ein Silan der allgemeinen Formel (II): 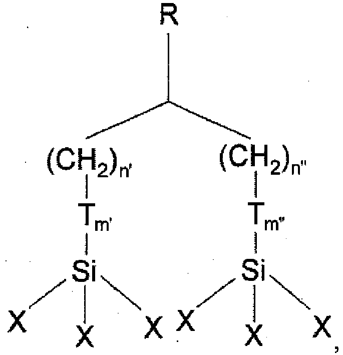 wobei
- X: für eine Alkoxy-, Acyloxy-, Halogen- oder Amingruppe steht,
- T: für eine substituierte oder unsubstituierte Arylen-Gruppe, insbesondere Phenylen-Gruppe, oder eine substituierte oder unsubstituierte Arylalkenylen- oder Arylalkylen-Gruppe, insbesondere eine Phenylalkenylen- oder Phenylalkylen-Gruppe, mit 7 bis 20, beispielsweise 8 bis 20, Kohlenstoffatomen, steht,
- m, m', m": jeweils unabhängig von einander für 0, 1 oder 2, insbesondere 0 oder 1, stehen,
- n, n', n": jeweils unabhängig von einander für eine Zahl ≥ 0 und ≤ 10, beispielsweise für 0, 1, 2 oder 3, insbesondere 2 oder 3, stehen, und
- R: für eine halogenierte oder unhalogenierte, insbesondere perfluorierte, Alkenyl- oder Alkyl-Gruppe, steht.

Im Rahmen einer weiteren, besonders bevorzugten Ausführungsform des erfindungsgemäßen Verfahrens umfasst die hydrophobe Beschichtung mindestens ein Silan der allgemeinen Formel (III):

R-(CH₂)₃-SiX₃

und/oder mindestens ein Silan der allgemeinen Formel (IV): 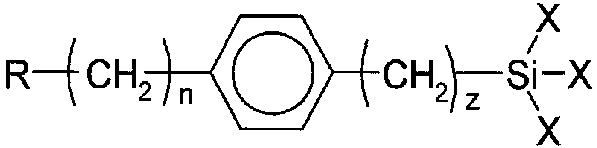 wobei
- X: für eine Alkoxy-, Acyloxy-, Halogen- oder Amingruppe steht, und
- R: für eine halogenierte oder unhalogenierte, insbesondere perfluorierte, Alkenyl- oder Alkyl-Gruppe, steht, und
- n, z: jeweils unabhängig von einander für eine Zahl ≥ 0 und ≤ 10, beispielsweise für 0, 1, 2 oder 3, insbesondere 0, 2 oder 3, stehen.

Hinsichtlich weiterer Ausführungsformen, spezieller Ausgestaltungen und Vorteile der im erfindungsgemäßen Verfahren applizierten Beschichtung wird hiermit explizit auf die Erläuterungen im Zusammenhang mit dem erfindungsgemäßen Wandler verwiesen.

## Patentansprüche

1. Piezoelektrischer Wandler, insbesondere auf Blei-Zirkonium-Titanat-Basis, **dadurch gekennzeichnet, dass** die Oberfläche des piezoelektrischen Wandlers eine hydrophobe Beschichtung und einen Elektroisolierlack aufweist, wobei der Elektroisolierlack direkt auf die hydrophobe Beschichtung aufgebracht ist.

2. Piezoelektrischer Wandler nach Anspruch 1, **dadurch gekennzeichnet, dass** die hydrophobe Beschichtung mindestens ein Silan umfasst.

3. Piezoelektrischer Wandler nach Anspruch 1, **dadurch gekennzeichnet, dass** der Elektroisolierlack auf Basis eines Epoxidharzes, insbesondere eines modifizierten Epoxidharzes gebildet ist.

4. Piezoelektrischer Wandler nach Anspruch 1 oder 2, **dadurch gekennzeichnet, dass** die hydrophobe Beschichtung die Silane umfasst, die zumindest bis zu einer Temperatur von 350 °C stabil sind.

5. Piezoelektrischer Wandler nach einem der Ansprüche 1, 2 oder 4, **dadurch gekennzeichnet, dass** die hydrophobe Beschichtung mindestens ein Silan der allgemeinen Formel (I):
R-(CH₂)ₙ-Tₘ-SiX₃
und/oder mindestens ein Silan der allgemeinen Formel (II): 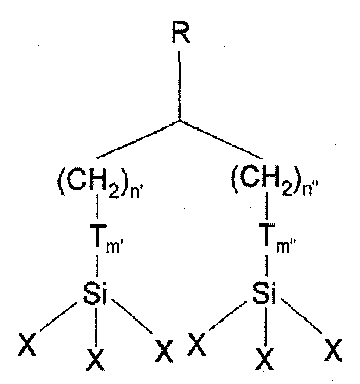 umfasst, wobei
X für eine Alkoxy-, Acyloxy-, Halogen- oder Amingruppe steht,
T für eine substituierte oder unsubstituierte Arylen-Gruppe oder eine substituierte oder unsubstituierte Arylalkenylen- oder Arylalkylen-Gruppe steht,
m, m', m" jeweils unabhängig von einander für 0, 1 oder 2 stehen,
n, n', n" jeweils unabhängig von einander für eine Zahl ≥ 0 und ≤ 10 stehen, und
R für eine halogenierte oder unhalogenierte Alkenyl- oder Alkyl-Gruppe steht.

6. Piezoelektrischer Wandler nach einem der Ansprüche 1, 2, 4 oder 5, **dadurch gekennzeichnet, dass** die hydrophobe Beschichtung mindestens ein Silan der allgemeinen Formel (III):
R-(CH₂)₃-SiX₃
und/oder mindestens ein Silan der allgemeinen Formel (IV): 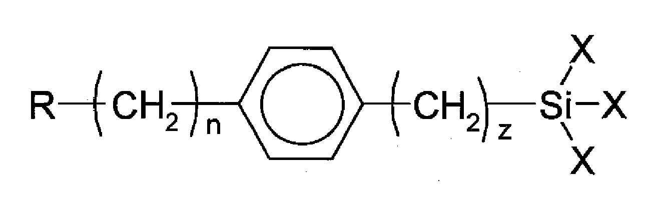 umfasst, wobei
X für eine Alkoxy-, Acyloxy-, Halogen- oder Amingruppe steht, und
R für eine halogenierte oder unhalogenierte Alkenyl- oder Alkyl-Gruppe steht, und
n, z jeweils unabhängig von einander für eine Zahl ≥ 0 und ≤ 10 stehen.

7. Verfahren zur Herstellung von piezoelektrischen Wandlern, insbesondere auf Blei-Zirkonium-Titanat-Basis, in dem die Oberfläche des piezoelektrischen Wandlers
- vor dem Löten von Bauteilen und/oder
- vor dem Waschen mit einer Waschlösung, und/oder
- nach dem Waschen mit einer Waschlösung,
teilweise oder vollständig mit einer hydrophoben Beschichtung versehen wird und anschließend mit einem Elektroisolierlack versehen wird, **dadurch gekennzeichnet, dass** der Elektroisolierlack direkt auf die hydrophobe Beschichtung aufgebracht wird.

8. Verfahren nach Anspruch 7, **dadurch gekennzeichnet, dass** die hydrophobe Beschichtung mindestens ein Silan umfasst.

9. Verfahren nach Anspruch 7, **dadurch gekennzeichnet, dass** der Elektroisolierlack auf Basis eines Epoxidharzes, insbesondere eines modifizierten Epoxidharzes gebildet wird.

10. Verfahren nach Anspruch 7 oder 8, **dadurch gekennzeichnet, dass** die hydrophobe Beschichtung die Silane umfasst, die zumindest bis zu einer Temperatur von 350 °C stabil sind.

11. Verfahren nach einem der Ansprüche 7, 8 oder 10, **dadurch gekennzeichnet, dass** die hydrophobe Beschichtung mindestens ein Silan der allgemeinen Formel (I):
R-(CH₂)ₙ-Tₘ-SiX₃
und/oder mindestens ein Silan der allgemeinen Formel (II): 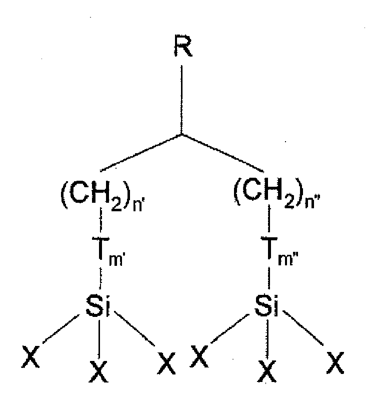 umfasst, wobei
X für eine Alkoxy-, Acyloxy-, Halogen- oder Amingruppe steht,
T für eine substituierte oder unsubstituierte Arylen-Gruppe oder eine substituierte oder unsubstituierte Arylalkenylen- oder Arylalkylen-Gruppe steht,
m, m', m" jeweils unabhängig von einander für 0, 1 oder 2 stehen,
n, n', n" jeweils unabhängig von einander für eine Zahl ≥ 0 und ≤ 10 stehen, und
R für eine halogenierte oder unhalogenierte Alkenyl- oder Alkyl-Gruppe steht.

12. Verfahren nach einem der Ansprüche 7, 8, 10 oder 11, **dadurch gekennzeichnet, dass** die hydrophobe Beschichtung mindestens ein Silan der allgemeinen Formel (III):
R-(CH₂)₃-SiX₃
und/oder mindestens ein Silan der allgemeinen Formel (IV): 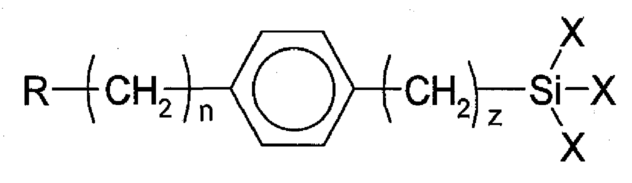 umfasst, wobei
X für eine Alkoxy-, Acyloxy-, Halogen- oder Amingruppe steht, und
R für eine halogenierte oder unhalogenierte Alkenyl- oder Alkyl-Gruppe steht, und
n, z jeweils unabhängig von einander für eine Zahl ≥ 0 und ≤ 10 stehen.

## Claims

1. Piezoelectric transducer, especially based on lead zirconium titanate, **characterized in that** the surface of the piezoelectric transducer has a hydrophobic coating and an electrical insulation varnish, with direct application of the electrical insulation varnish to the hydrophobic coating.

2. Piezoelectric transducer according to Claim 1, **characterized in that** the hydrophobic coating comprises at least one silane.

3. Piezoelectric transducer according to Claim 1, **characterized in that** the electrical insulation varnish is based on an epoxy resin, especially a modified epoxy resin.

4. Piezoelectric transducer according to Claim 1 or 2, **characterized in that** the hydrophobic coating comprises the silanes which are stable at least up to a temperature of 350°C.

5. Piezoelectric transducer according to any of Claims 1, 2 and 4, **characterized in that** the hydrophobic coating comprises at least one silane of the general formula (I):
R- (CH₂)ₙ-Tₘ-SiX₃
and/or at least one silane of the general formula (II) : 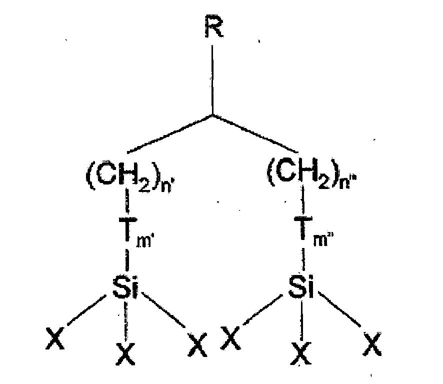 where
X is an alkoxy, acyloxy, halogen or amine group,
T is a substituted or unsubstituted arylene group or a substituted or unsubstituted arylalkenylene or arylalkylene group,
m, m', m" are each independently 0, 1 or 2,
n, n', n" are each independently a number ≥ 0 and ≤ 10, and
R is a halogenated or unhalogenated alkenyl or alkyl group.

6. Piezoelectric transducer according to any of Claims 1, 2, 4 and 5, **characterized in that** the hydrophobic coating comprises at least one silane of the general formula (III):
R- (CH₂)₃-SiX₃
and/or at least one silane of the general formula (IV) : 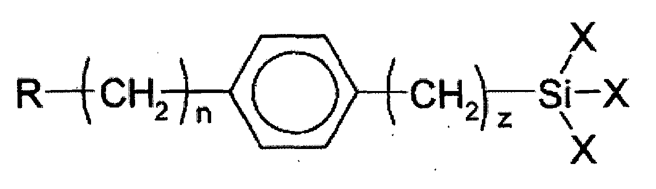 where
X is an alkoxy, acyloxy, halogen or amine group,
R is a halogenated or unhalogenated alkenyl or alkyl group, and
n, z are each independently a number ≥ 0 and ≤ 10.

7. Method of producing piezoelectric transducers, especially based on lead zirconium titanate, in which the surface of the piezoelectric transducer
- prior to soldering of components and/or
- prior to washing with a wash solution and/or
- after washing with a wash solution
is provided partly or fully with a hydrophobic coating and
then is provided with an electrical insulation varnish, **characterized in that** the electrical insulation varnish is applied directly to the hydrophobic coating.

8. Method according to Claim 7, **characterized in that** the hydrophobic coating comprises at least one silane.

9. Method according to Claim 7, **characterized in that** the electrical insulation varnish is based on an epoxy resin, especially a modified epoxy resin.

10. Method according to Claim 7 or 8, **characterized in that** the hydrophobic coating comprises the silanes which are stable at least up to a temperature of 350°C.

11. Method according to any of Claims 7, 8 and 10, **characterized in that** the hydrophobic coating comprises at least one silane of the general formula (I):
R- (CH₂)ₙ-Tₘ-SiX₃
and/or at least one silane of the general formula (II) : 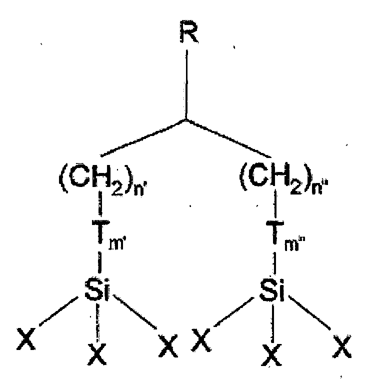 where
X is an alkoxy, acyloxy, halogen or amine group,
T is a substituted or unsubstituted arylene group or a substituted or unsubstituted arylalkenylene or arylalkylene group,
m, m', m" are each independently 0, 1 or 2,
n, n', n" are each independently a number ≥ 0 and ≤ 10, and
R is a halogenated or unhalogenated alkenyl or alkyl group.

12. Method according to any of Claims 7, 8, 10 and 11, **characterized in that** the hydrophobic coating comprises at least one silane of the general formula (III):
R- (CH₂)₃-SiX₃
and/or at least one silane of the general formula (IV) : 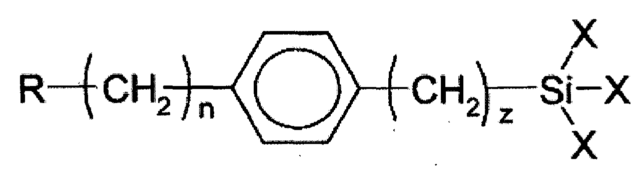 where
X is an alkoxy, acyloxy, halogen or amine group,
R is a halogenated or unhalogenated alkenyl or alkyl group, and
n, z are each independently a number ≥ 0 and ≤ 10.

## Revendications

1. Convertisseur piézoélectrique, en particulier à base de titanate de plomb-zirconium, **caractérisé en ce que** la surface du convertisseur piézoélectrique présente un revêtement hydrophobe et une laque d'isolation électrique, la laque d'isolation électrique étant appliquée directement sur le revêtement hydrophobe.

2. Convertisseur piézoélectrique selon la revendication 1, **caractérisé en ce que** le revêtement hydrophobe comprend au moins un silane.

3. Convertisseur piézoélectrique selon la revendication 1, **caractérisé en ce que** la laque d'isolation électrique est formée sur base d'une résine époxyde, en particulier d'une résine époxyde modifiée.

4. Convertisseur piézoélectrique selon la revendication 1 ou 2, **caractérisé en ce que** le revêtement hydrophobe comprend les silanes qui sont stables au moins jusqu'à une température de 350°C.

5. Convertisseur piézoélectrique selon l'une quelconque des revendications 1, 2 ou 4, **caractérisé en ce que** le revêtement hydrophobe comprend au moins un silane de formule générale (I) :
R-(CH₂)ₙ-Tₘ-SiX₃
et/ou au moins un silane de formule générale (II) : 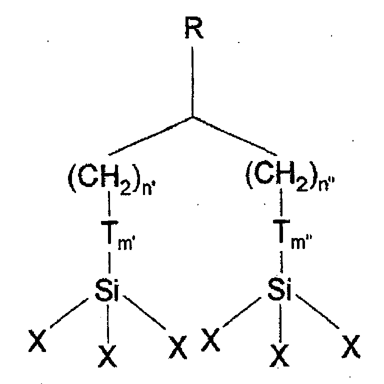 dans lesquelles
X représente un groupe alcoxy, acyloxy, halogène ou amino,
T représente un groupe arylène substitué ou non substitué ou un groupe arylalcénylène ou arylalkylène substitué ou non substitué,
m, m', m" valent à chaque fois, indépendamment les uns des autres, 0, 1 ou 2,
n, n', n" représentent à chaque fois, indépendamment les uns des autres, un nombre ≥ à 0 et ≤ à 10 et
R représente un groupe alcényle ou alkyle halogéné ou non halogéné.

6. Convertisseur piézoélectrique selon l'une quelconque des revendications 1, 2, 4 ou 5, **caractérisé en ce que** le revêtement hydrophobe comprend au moins un silane de formule générale (III) :
R-(CH₂)₃-SiX₃
et/ou au moins un silane de formule générale (IV) : 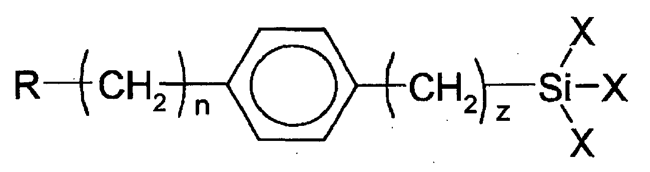 dans lesquelles
X représente un groupe alcoxy, acyloxy, halogène ou amino et
R représente un groupe alcényle ou alkyle halogéné ou non halogéné et
n, z représentent à chaque fois, indépendamment l'un de l'autre, un nombre ≥ à 0 et ≤ à 10.

7. Procédé pour la production de convertisseurs piézoélectriques, en particulier à base de titanate de plomb-zirconium, dans lequel la surface du convertisseur piézoélectrique est pourvue
- avant le brasage de pièces et/ou
- avant le lavage avec une solution de lavage et/ou
- après le lavage avec une solution de lavage,
partiellement ou totalement d'un revêtement hydrophobe et ensuite pourvue d'une laque d'isolation électrique, **caractérisé en ce que** la laque d'isolation électrique est appliquée directement sur le revêtement hydrophobe.

8. Procédé selon la revendication 7, **caractérisé en ce que** le revêtement hydrophobe comprend au moins un silane.

9. Procédé selon la revendication 7, **caractérisé en ce que** la laque d'isolation électrique est formée sur base d'une résine époxyde, en particulier d'une résine époxyde modifiée.

10. Procédé selon la revendication 7 ou 8, **caractérisé en ce que** le revêtement hydrophobe comprend les silanes qui sont stables au moins jusqu'à une température de 350°C.

11. Procédé selon l'une quelconque des revendications 7, 8 ou 10, **caractérisé en ce que** le revêtement hydrophobe comprend au moins un silane de formule générale (I) :
**R-(CH₂)ₙ-Tₘ-SiX₃**
et/ou au moins un silane de formule générale (II) : 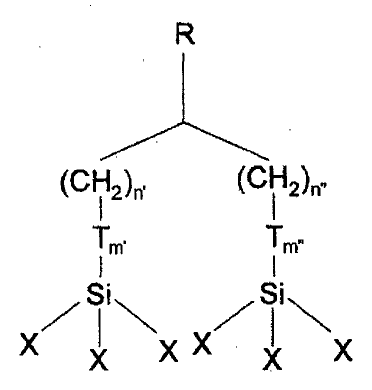 dans lesquelles
X représente un groupe alcoxy, acyloxy, halogène ou amino,
T représente un groupe arylène substitué ou non substitué ou un groupe arylalcénylène ou arylalkylène substitué ou non substitué,
m, m', m" valent à chaque fois, indépendamment les uns des autres, 0, 1 ou 2,
n, n', n" représentent à chaque fois, indépendamment les uns des autres, un nombre ≥ à 0 et ≤ à 10 et
R représente un groupe alcényle ou alkyle halogéné ou non halogéné.

12. Procédé selon l'une quelconque des revendications 7, 8, 10 ou 11, **caractérisé en ce que** le revêtement hydrophobe comprend au moins un silane de formule générale (III) :
**R-(CH₂)₃-SiX₃**
et/ou au moins un silane de formule générale (IV) : 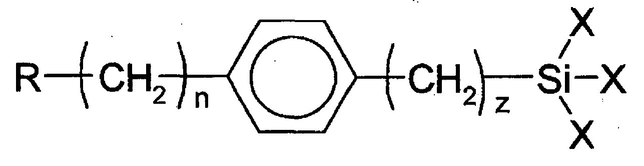 dans lesquelles
X représente un groupe alcoxy, acyloxy, halogène ou amino et
R représente un groupe alcényle ou alkyle halogéné ou non halogéné et
n, z représentent à chaque fois, indépendamment l'un de l'autre, un nombre ≥ à 0 et ≤ à 10.
